(19) Europäisches Patentamt
European Patent Office
Office européen des brevets

(11) Publication number: **0 003 262 B1**

(12) # EUROPEAN PATENT SPECIFICATION

(45) Date of publication of patent specification: **06.11.85**

(51) Int. Cl.[4]: **G 11 B 7/24,** H 04 N 5/82, G 11 C 13/04, B 41 M 5/26

(21) Application number: **78300865.9**

(22) Date of filing: **19.12.78**

(54) **Medium, process and system for recording information.**

(30) Priority: **19.12.77 US 862069**

(43) Date of publication of application: **08.08.79 Bulletin 79/16**

(45) Publication of the grant of the patent: **06.11.85 Bulletin 85/45**

(84) Designated Contracting States: **BE FR GB IT NL**

(56) References cited:
**DE-A-2 522 928**
**DE-A-2 740 505**
**FR-A-2 111 201**
**FR-A-2 344 920**
**FR-A-2 368 779**
**US-A-3 448 458**
**US-A-3 475 760**
**US-A-4 023 185**

(73) Proprietor: **EASTMAN KODAK COMPANY**
**343 State Street**
**Rochester New York 14650 (US)**

(72) Inventor: **Thomas, Harold Todd**
**Kodak Park**
**Rochester New York (US)**
Inventor: **Wrobel, Joseph Jude**
**Kodak Park**
**Rochester New York (US)**

(74) Representative: **Baron, Paul Alexander Clifford et al**
**Kodak Limited Patent Department Headstone Drive**
**Harrow Middlesex HA1 4TY (GB)**

EP 0 003 262 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The invention relates to a medium, process and system for recording information.

More particularly the invention provides a medium having a solvent-coated layer capable of being thermally deformed, during recording, in such a way that deformations occur at a high packing density, i.e., a large amount of information may be recorded per unit area of the medium. The recorded information can be read out with a high signal-to-noise ratio and few imperfections or dropouts. The medium can therefore be used for high quality recording of information at high packing density, and as such is useful for the recording of video information.

"Solvent-coated" as used herein means that the layer material is coated from a liquid solution in a solvent.

Media for recording information by thermally altering the physical structure of a material are known. U.S. Patent No. 3,475,760 describes a medium for recording information as a thermal deformation pattern (doing so without requiring the formation of an electrical charge pattern on the medium). The medium is a 1 to 10 µm thick layer of a solvent-coated thermoplastic material on a support. The patent teaches that some thermoplastic materials, modified to absorb radiation strongly at the wavelength of a laser beam having a diameter of less than 10 µm, can be thermally deformed by that laser beam so that some of the thermoplastic material is displaced from the area illuminated by the beam and forms ridges along the edges of that area. This deformation pattern retains its shape after the laser beam is "removed" and may be read by projecting the pattern onto a viewing screen as a Schlieren image, and viewing the image through Schlieren optics.

U.S. Patent No. 3,475,760 does not, however, teach or suggest that solvent-coated materials could be used to form a medium to record video signals with such high quality that the recording could be read back with a signal-to-noise ratio greater than 40 decibels. Such a recording medium would be very desirable because it could then be possible, for example, to inexpensively manufacture a 30.5-cm (12-inch) circular disc using solvent-coating methods, the disc being suitable for recording at least one half hour of real-time video programming per disc side.

Newer developments such as those disclosed in U.S. Patent No. 4,023,185 provide a medium and a means for rapidly recording large amounts of information in a small area in such a way that the information can be read back with a high signal-to-noise ratio. The medium employs a thin (0.0525 µm) recording layer of 4-phenylazo-1-naphthylamine which is vapour deposited in a vacuum on a support. The recording means comprises a beam of high energy-density radiation, such as a laser beam. Typically, the laser beam is modulated, e.g. pulsed corresponding to a pattern of information, and focused onto the surface of the recording layer. The recording layer has reasonably high absorbance at the wavelength of the laser beam so that the laser can transfer enough energy to small portions of the layer to burn, evaporate, or otherwise remove the organic material from those portions. This technique is usually referred to as ablative recording. Normally there is continuous relative motion between the laser and the layer so that, as the laser is pulsed or modulated, discrete holes of varying sizes are created in the layer. The sizes and spacings of these holes constitute the encoded information. When a lower power laser beam of the same wavelength is arranged to follow the path of the recording beam at the same speed, the light reflected back from the recorded holes to a photodetector is converted into an electrical signal corresponding to the information recorded.

As previously mentioned, U.S. Patent 4,023,185 discloses that the recording layer of such media known to be useful comprises a layer of 4-phenylazo-1-naphthylamine. Unfortunately, this material can only be coated in layers of the desired thickness on a support by the relatively expensive and time-consuming technique of vapour deposition in a vacuum.

Belgian Patent No. 858,636 published 13 March 1978 describes a material for recording the information carried by a modulated laser beam comprising a support bearing a 0.5 to 10 µm thick recording layer comprising a thermoplastic polymer having dissolved therein up to 10 percent by weight of an organic dye which provides a specular density of at least 0.1 to the layer with respect to the wavelength of the recording laser. Such recording material is said to develop light scattering centres with a minimum increase of white light specular density of 0.2 with respect to the background when exposed to a light energy dose of at least $1 \times 10^6$ erg/cm$^2$ (0.1 watt sec/cm$^2$) with a focused laser beam having a beam intensity of at least $1.0 \times 10^{11}$ erg/cm$^2$ sec. ($1 \times 10^4$ watts/cm$^2$). Information recorded on such recording material is read by scanning with the recording laser beam with its power reduced to about one tenth of that used for recording.

All the recording materials mentioned above can be used to record an information modulated laser beam by thermal deformation or by ablation of a layer of laser energy-absorbing material. However, none of the materials which record by thermal deformation has proved to be suitable for recording a modulated laser beam in which the modulating signal is a colour video signal. In such a recording system the modulating signal contains at least $5 \times 10^6$ bits of information per second and the signal-to-noise ratio on playback must be 40 decibels or greater.

The recording material decribed in U.S. Patent No. 4,023,185 may be able to record a colour video signal and be played back with the desired signal-to-noise ratio. However, this recording material cannot be prepared by the simple method of solvent coating. It must be prepared by the relatively expensive

technique of vacuum-evaporative deposition. Furthermore, this recording material is not reusable.

The present invention provides a recording medium having the desirable characteristics described above.

During experimentation with various materials for recording with a modulated argon ion laser, it was found that a high quality, high information-density, recording material could be prepared by solvent coating an extremely thin, amorphous layer comprising a mixture of a thermoplastic binder and a dye which absorbs energy at the wavelength of the recording beam, i.e., 488 nanometers. It was also discovered that the recorded information could be read using a laser of a different wavelength than that which the dye absorbs, e.g., a helium-neon laser at 633 nanometers.

Upon close inspection of the recording surface with a scanning electron-microscope, it was found that — whether holes were created or not — depressions surrounded by sharply defined ridges were formed in the amorphous material. The good reading made with the helium-neon laser appears to be caused by the laser-light-scattering effect of the ridges; i.e., the sharp change toward "vertical" in the surface of the amorphous material at the ridges from the "horizontal" surface of the undeformed areas causes sufficient light-scattering to produce a good density variation when a reading scan is made with the helium-neon laser.

The present invention provides a medium for recording at least $5 \times 10^6$ bits per second of information which is pulse-encoded on a recording beam of high energy density radiation, said medium comprising a support bearing a recording layer, characterized in that,

(1) the recording layer has a thickness less than 0.45 μm and consists of an amorphous material comprising a thermoplastic binder and a dye,

(2) the amorphous material has an absorption factor of at least 20 at a first wavelength and is substantially transparent at a second wavelength wherein the absorption factor is the product of the weight fraction of dye in the recording layer and the molar extinction coefficient of the dye at the wavelength of a recording beam divided by the molecular weight of the dye, and

(3) the amorphous material is capable of being thermally deformed by a beam of high energy density radiation of said first wavelength scanned in relative motion to the recording layer to form deformations comprising depressions or holes surrounded by sharply defined ridges, the width R of each ridge being less than or equal to the breadth D of the depression or hole, as measured in the plane of the undeformed surface of the layer and in the direction of the relative motion between the recording beam and the layer, which deformations represented encoded information capable of being detected by a beam of high energy density radiation of said second wavelength.

The recording layer is preferably less than 0.35 μm thick. It comprises an amorphous material having an absorption factor at the wavelength of a recording beam, greater than 20; and the material is capable of being thermally deformed by the recording beam (without the aid of electrical charge patterns) to form a hole or depression surrounded by a sharply defined ridge. The ridge and hole/depression must have noticeable boundaries and "sharply defined ridge" means that, as measured in the plane of the undeformed outer surface of the layer and in the direction or relative motion between the recording beam and the layer, the width of the ridge is less than or equal to the breadth of the hole/depression.

A medium according to the invention as defined can be recorded upon so that the size of each discrete deformation-bit of recorded information is preferably smaller than 1.5 μm, and the information can be read back with a signal-to-noise ratio of 40 decibels or greater.

A recording medium in accodance with a preferred form of the invention is capable of being recorded upon, erased, and recorded upon again.

If the recording medium of the invention is to be used as a master for producing replicate recordings, it is useful in some embodiments to incorporate into the amorphous material another dye having high absorbency at a wavelength of radiation useful for recording upon a replicate recording medium. In such a case the support must be substantially transparent at that wavelength.

Another useful method of producing replicates from the medium of the invention is to deposit a metal layer on the deformed surface of the recorded medium, strip the metal layer off, and use the stripped-off metal layer as a mold to press out replicate recordings.

In accordance with another aspect of the invention there is provided a method of writing information which is pulsed-encoded on a recording beam of high energy density radiation on a medium for recording at least $5 \times 10^6$ bits per second of information comprising a support bearing a recording layer wherein the recording beam is scanned in relative motion to the recording layer, characterized in that

(1) the recording layer has a thickness of less than 0.45 μm and consists of an amorphous material comprising a thermoplastic binder and a dye,

(2) the amorphous material has an absorption factor of at least 20 at a first wavelength and is substantially transparent at a second wavelength wherein the absorption factor is the product of the weight fraction of dye in the recording layer and the molar extinction coefficient of the dye at the wavelength of a recording beam divided by the molecular weight of the dye, and

(3) the recording beam is of the first wavelength and produces as plurality of deformations in the recording layer, said deformations comprising depressions or holes surrounded by sharply defined ridges, the width R of each ridge being less than or equal to the breadth D of the depression or hole, as measured in the plane of the undeformed surface of the layer and in the direction of relative motion between the

recording beam and the layer, which deformations represent encoded information capable of being detected by a beam of high energy density radiation of said second wavelength.

In certain preferred embodiments of the invention the recording beam of high energy density radiation is an argon ion laser beam and the recording layer comprises:

(a) one part by weight of cellulose nitrate and one part by weight of Eastone Red R, Eastone Red B, Sudan IV or 1-(2-pyridylazo)-2-naphthol;

(b) one part by weight of hydroabietyl alcohol and one part by weight of SK1 or SK2;

(c) one to three parts by weight of cellulose nitrate and one part by weight of SK1 or SK2;

(d) one part by weight of hydroabietyl alcohol, one part by weight of cellulose nitrate and one part by weight of SK1 or SK2; or

(e) one part by weight of cellulose nitrate and one to three parts by weight of "Iosol Red".

The invention also provides a system for recording information pulse-encoded on a high energy beam which system comprises means for producing the beam containing the pulse-encoded information, a recording medium of the invention, means for focussing the beam on the recording layer and means for scanning the beam in relative motion to the recording layer whereby, when in use, deformations are produced in the layer comprising depressions or holes surrounded by sharply defined ridges.

The invention is further illustrated with reference to the accompanying drawings wherein

Fig. 1 is a cross-sectional view of a portion of a recording medium of the invention.

Fig. 2 is a cross-sectional view of the recording medium of Fig. 1 after it has been recorded upon, and

Fig. 3 is a cross-sectional view of a portion of a recording medium that has been recorded upon and that does not fall within the definition of the invention. It is included for purposes of comparison with Fig. 2.

A recording medium of the invention is suitable for high quality, high information-density recording. "High quality recording" as used herein is defined as a recording which when read back has a signal-to-noise ratio of 40 decibels or greater, and few imperfections or dropouts. "High information-density recording" as used herein is defined as a recording in which discrete bits of information are in the form of deformations having respective sizes smaller than 1.5 μm. "Size" is defined, referring preliminarily to Fig. 2 of the drawings, as the sum of the dimensions R plus D plus R, i.e., the ridge-width plus the depression-breadth plus the ridge-width, measured in the plane of the undeformed outer surface of the layer 10 and in the direction of relative motion between a recording beam and the recording layer.

Referring to Fig. 1 of the drawings, the recording medium comprises a layer 10 of amorphous material less than 0.45 μm thick coated from a solvent onto a support 20. The solvent-coating may be any of the widely known thin-layer solvent-coating techniques such as bar-coating, spray-coating and whirl-coating. The thickness M of the amorphous layer must be less than 0.45 μm because thicker layers have heat-dissipation and flow properties that render them incapable of being thermally deformed by a recording beam to form the physical surface-structure necessary to the practice of the invention. The layer should have a significant optical density, i.e., absorption factor of 20 or greater at the wavelength of the recording beam of choice, in order to be able to absorb sufficient energy from the recording beam to undergo proper thermal deformation. The layer preferably has a glass transition temperature significantly higher than room temperature and lower than the temperature that can be imparted to a point on the layer by the recording beam of choice. Otherwise, the layer may not be able to retain the thermal deformation pattern after recording or may not be capable of being recorded upon at all.

The particular deformation structure that provides the high degree of radiation-scattering necessary for high-quality, high information-density recording and reading according to the invention is illustrated in Fig. 2 of the drawings. Fig. 2 shows that the ridge-width R is less than or equal to the breadth D of the depression (or hole, dashed line 21) after recording. This provides a practical test for identifying amorphous materials suitable for use in the invention. A recording beam can be focussed on the material and then the resultant deformation viewed, for example, through a scanning electron microscope. By using a comparative scale, the ridge-width and depression-breadth can be measured in the plane of the undeformed surface and in the direction in which the recording beam was moved. If the ridge width is not less than or equal to the breadth of the depression (hole), or if the ridge and depression (hole) are not defined sharply enough to make such measurements, the amorphous material is not a useful one. In performing such a test an exposure series should be made. That is, the power of the recording beam or the recording time should be varied so that a series of attempted recordings is made which covers a range extending from the point where no deformation occurs (low power or short exposure time) to the point where actual vaporization or burning off of the amorphous material occurs (high power or long exposure time). The measurements should then be made of the step in the exposure series that provides the most sharply defined ridge and depression, if any.

Fig. 3 is included to illustrate a situation where the amorphous material is not a useful one or where the thickness M' of the amorphous layer 30 is greater than 0.45 μm. It can be seen that in this case, after recording, the ridge-width R', is greater than the depression-breadth D'. It will also be realized that it is difficult even to make the measurements in this case because the ridge is so ill-defined that it is difficult to decide where the gently sloping ridge ends and the undeformed portion of the layer begins. The radiation-scattering effect of such a gently sloping deformation is not sufficient for high quality, high information-density recording.

The amorphous material of the invention is a mixture of a binder and an absorptive substance such as

a dye chosen for its high absorptivity at the wavelength of the recording beam. The absorptive substance must be compatible with the binder (be able to mix with the binder in such a way that no crystalline structure is formed), or the resultant material will not be useful for the invention. The mixture normally comprises a binder to dye ratio of 1:1 by weight, but in some cases it may be preferred to increase the ratio to 3:1 or more or to decrease the ratio to 1:3 or less. In some cases it may also be useful to include a plasticizer in the mixture to achieve the desired deformation capabilities. As mentioned previously the amorphous material must also be soluble in a solvent, such as cyclohexanone, acetone, benzene and xylene.

Preferred binders are, for example, a cellulose acetate butyrate, a polystyrene, a polysulphonamide, a polycarbonate (e.g. Lexan), a cellulose nitrate, hydroabietyl alcohol (sold by the Hercules Chemical Co. as Abitol AUK 257), a poly(ethyl methacrylate), a poly(vinyl butyral), or a combination thereof.

A dye is chosen for its compatibility with the binder of choice and for its high absorptivity at the wavelength of the recording beam of choice. Innumerable dyes are available and well known. When the recording beam is to be one produced by an argonion laser (wavelength = 488 nm), suitable dyes include but are not limited to: Iosol Red (absorption factor at 488 nm = 40); Eastone Red R (available from Eastman Kodak Company) having the structural formula:

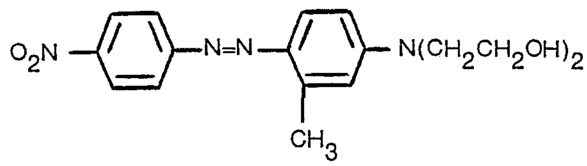

absorption factor at 488 nm of 74.2;
and Eastone Red B (available from Eastman Kodak Company) having the structural formula:

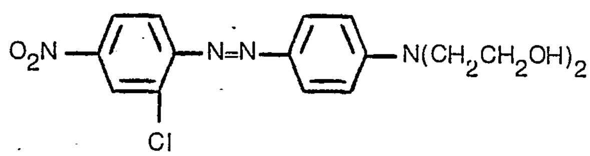

absorption factor at 488 nm of 79.5;
Sudan IV, having the structural formula:

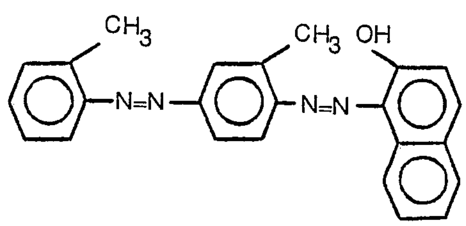

absorption factor at 488 nm of 66;
1-(2-pyridylazo)-2-napthol, having the structural formula:

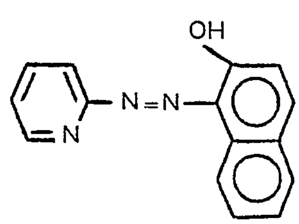

absorption factor at 488 nm of 62;

SK1 having the structural formula:

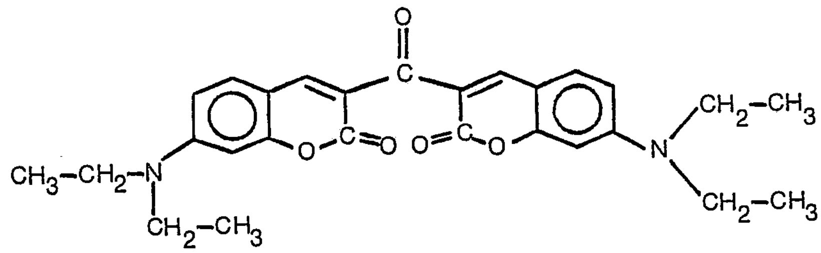

having an absorption factor at 488 nm of 128;
and SK2 having the structural formula:

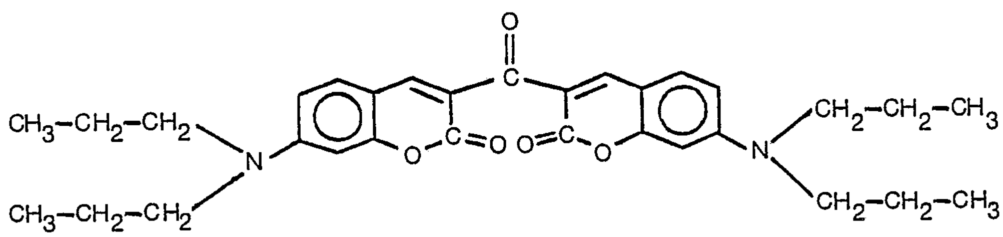

having an absorption factor of 123.

The preparation and utility of coumarin compounds such as SK1 and SK2 are described in *"Research Disclosure"* Publication No. 16167 by Ind. Opp. Ltd. U.K.

If the recording medium is to be used as a master record for producing replicate records, it is useful in some embodiments to incorporate into the amorphous material an additional dye having high absorbency at a wavelength of radiation useful for recording upon a replicate recording medium. In such a case the support must be substantially transparent at that wavelength.

Another useful method of producing replicates from the recorded medium of the invention is to deposit a metal layer on the deformed surface of the recorded medium by a known technique such as chemical plating or vacuum deposition, and then to strip the metal layer off and use it as a press out replicate recordings (much in the same way as present-day replicate phonograph records are produced).

Referring again to Fig. 1, the support 20 may be rigid or flexible and transparent or reflective, depending upon the way it is to be used. The support may comprise any of a virtually unlimited number of materials, for example, glass plate, glass plate coated with 50 nm (500Å) thick reflective layer of aluminium, a resin film or plate such as polyethylene terephthalate or cellulose acetate, paper, clay, wood, or metal. Important characteristics of the support are that it have a relatively high melting point (to avoid deformation during recording) a very smooth surface (to minimize noise) and that it be capable of being solvent-coated with a layer of amorphous material less than 0.45 µm thick, with good adhesion and no significant chemical reactivity between the layer and the support.

The recording medium of the present invention is suitable for making a high quality recording by thermally deforming the medium with a recording beam, such as a laser beam, that is pulse-encoded with the information being recorded. There is usually continuous relative motion between the surface of the recording layer and the recording beam. The rate of this relative motion (scanning speed) may vary, and the recording beam may have varying power and diameter. The peak power delivered to the surface of the recording layer is from 2 to 10 milliwatts in the examples provided below but is not limited to that range. The beam diameter may also vary widely, being about 0.75 µm or less in the examples, but it may be larger, depending on the size of the deformation desired. The scanning speed may also vary. In the examples, the scanning speeds used resulted in 45 to 55 nanosecond exposures per recorded bit of information.

The information may be read back by use of the recording beam, with its power, of course, reduced sufficiently so as not to cause any further thermal deformation. With a recording medium of the invention, however, the reading beam need not have a wavelength that is absorbed to any extent by the amorphous layer of material because reading depends not on absorbance but on the radiation-scattering effects of the surface deformations. Schlieren optics may be used advantageously during reading but are not required. The reading beam cooperates with a photodetector which detects the sizes of and spacings between deformations by way of their radiation-scattering effects.

In some embodiments of the invention, as previously mentioned, the recorded information can be erased by heating the whole surface of the recorded medium with a hot air-stream until surface tension

smooths out the surface or by following techniques such as those described in U.S. Patent No. 3,475,760. The medium can then be recorded upon again. This cycle may be repeated a large number of times, depending upon whether any significant portion of the amorphous material has been lost because of vapourization or burning during recording. A recording medium having a recording layer less than 0.45 µm thick, comprising a 3 to 1 mixture of Iosol Red and cellulose nitrate, is a good example of a recording medium that is erasable and recordable.

The following examples are provided to further illustrate preferred embodiments of the invention:

### Example 1

1.0 g of the dye SK1 (defined previously) was mixed with 1.0 g of cellulose nitrate. The mixture was dissolved in 120 g of cyclohexanone, filtered through a filter having a pore size of 0.45 micron and whirl-coated at 200 RPM onto a circular glass plate having a diameter of about 30.5 cms (12 inches), a thickness of about 0.64 cm (1/4 inch), and a 50 nm (500Å) thick layer of aluminium on the surface being coated. The resultant dried layer of amorphous material had a thickness of approximately 0.16 µm and an absorption factor of 64 at 488 nanometers.

Information from a colour video signal was recorded upon this medium using an argon-ion laser (wavelength = 488 nm) having a beam diameter of about 0.7 µm. Each discrete bit of information was recorded as a deformation consisting of a depression surrounded by sharply defined ridges. The information was read back using a helium-neon laser (wavelength = 633 nm), and yielded a signal having a signal-to-noise ratio of 52 decibels with few imperfections or dropouts.

### Example 2

0.5 g of the dye SK1 was mixed with 1.0 g of cellulose nitrate. The mixture was dissolved in 60 g of cyclohexanone, filtered through a filter having a pore size of 0.45 µm, and whirl-coated at 400 RPM onto an aluminized glass plate as in Example 1, to a thickness of about 0.16 µm and an absorption factor at 488 nm of 43.

Information from a colour video signal was recorded upon this medium using an argon-ion laser. Each discrete bit of information was recorded as a deformation having a size smaller than 1.5 µm consisting of a depression surrounded by sharply defined ridges. The information was read back using a helium-neon laser, and yielded a signal-to-noise ratio of 54 decibels with few imperfections or dropouts.

### Example 3

3.0 g of Iosol Red dye was mixed with 1.0 g of cellulose nitrate, dissolved in 80 g of cyclohexanone, filtered to 0.45 µm absolute, and whirl-coated, at 1050 RPM onto an aluminized glass plate as in Example 1, to a thickness of about 0.16 micron and an absorption factor at 488 nm of 30.

Colour video signal information was recorded upon this medium using an argon-ion laser. Each discrete bit of information was recorded as a deformation consisting of a depression surrounded by sharply defined ridges. The information was read back using a helium-neon laser, and yielded a signal-to-noise ratio of 48 db with few imperfections or dropouts. This recording was erased with heat and re-recorded, the cycle being repeated three times with equal performance.

### Example 4

1.0 g of the dye SK1 was mixed with 1.0 g of Abitol AUK 257, dissolved in 50 g of cyclohexanone, and whirl-coated as in Example 3. The layer had an absorption factor of 64.

Colour video signal information was recorded upon this medium using an argon-ion laser. Each discrete bit of information was recorded as a deformation consisting of a depression surrounded by sharply defined ridges. The information was read back using a helium-neon laser, and yielded a signal-to-noise ratio of 48 db with few imperfections or dropouts. This recording was erased with heat and re-recorded with good performance.

### Example 5

A number of amorphous materials were prepared, coated, and recorded upon as in the previous examples. Recording power ranged from about 2 to 10 milliwatts at a beam diameter of about 0.7 µm. The specific materials and their performances are listed in Table I. All of these materials were chosen for their capability of being thermally deformed to form depressions surrounded by sharply defined ridges.

TABLE I

Performance of Various Amorphous Recording Materials

| Dye | Binder | wt. ratio dye to binder | Absorption Factor | Performance S/N ratio in db. |
|---|---|---|---|---|
| Eastone Red R | cellulose acetate butyrate | 1:1 | 37 | 43 |
| Eastone Red R | cellulose nitrate | 1:1 | 37 | 50 |
| SK1 | Abitol | 1:1 | 64 | 48 erasable and recordable |
| SK1 | Poly(ethyl methacrylate) | 1:1 | 64 | 42–46 |
| SK1 | cellulose nitrate | 1:2 | 43 | 54 |
| SK1 | cellulose nitrate | 1:3 | 32 | 46 |
| SK1 | cellulose nitrate | 1:4 | 21 | 43 |
| SK1 | Abitol + cellulose nitrate | 1:1:1 | 43 | 43 |
| SK1 | Abitol + cellulose nitrate | 2:1:1 | 64 | 50 |
| Sudan IV | cellulose nitrate | 1:1 | 33 | 45 |
| 1-(2-pyridylazo-2-naphthol | cellulose nitrate | 1 : 1 | 31 | 47 |
| Eastone Red R | Poly(vinyl butyral) | 1:1 | 37 | 44 |
| SK2 | Polystyrene(MW9000) | 1:1 | 62 | 43 |
| Iosol Red | none | 1:0 | 40 | 48 self-erases with time at room temp. |
| Iosol Red | cellulose nitrate | 1:1 | 20 | 48 |
| Iosol Red | cellulose nitrate | 3:1 | 30 | 48 erasable and recordable |
| Eastone Red B | cellulose nitrate | 1:1 | 40 | 50 |

In order to differentiate the present invention from that of Belgian Patent No. 858,636, several experimental recording materials were prepared. These experiments are reported in the following comparative examples.

Comparative Example 1

A coating composition according to Example 1 of Belgian Patent No. 858,636 was prepared by dissolving 20 mg of Solvent Red 1 dye in 10 ml of a 10 percent weight (g) per volume (ml) solution of PARLON 300 Cp in 1,1,2-trichloroethylene. This coating composition was 2% by weight of dye with respect to the thermoplastic polymer. It was whirl-coated onto a 30.5 cms (12 inch) diameter aluminized glass plate and dried at 25°C to obtain a recording medium having a specular optical density of 0.37. The absorption factor of the coating at 488 nm was only 3.

It was not possible to record a color video signal on this medium using the recording procedure described in Example 5, above.

This experiment shows that the recording material according to this invention must have an absorption factor, as hereinbefore defined, of 20 or greater to produce a satisfactory, high quality recording.

Comparative Example 2

A coating composition was prepared by dissolving 0.1 gram of the dye SK1 in 10 ml of a 9% by weight solution of PARLON 300 Cp in cyclohexanone. This is the maximum permissible ratio of dye to polymer according to Belgian Patent No. 858,636. This solution was whirl-coated onto a 30.5 cms. (12 inch) diameter, aluminized glass plate to give a specular density of 0.88. The absorption factor of the recording layer was 13 at 488 nm.

It was attempted to record a colour video signal on this medium using the procedure described in Example 5. On microscopic examination it was noted that slight deformations had been formed in the recording layer but it was impossible to obtain a picture on playback.

This experiment shows that employing a useful dye (see Examples 1,2,4 and 5) at only 10% by weight based on the thermoplastic polymer results in a recording layer having a low absorption factor which is not satisfactory for the purposes of this invention.

Comparative Example 3

A coating composition was prepared by dissolving 0.1 gram of the dye SK1 and 1 g of cellulose nitrate in 100 g of cyclohexanone. The solution was filtered as in Example 1 and whirl-coated on a 30.5 cms (12 inch) aluminized glass disc at a specular density of 0.88. The absorption factor of the recording layer was 13 at 488 nm and the layer thickness was 0.75 µm.

It was not possible to record a colour video signal on this medium using the recording procedure described in Example 5.

A second recording material was prepared with this coating composition at a thickness of 0.15 µm. This medium had a specular density of 0.18 and was not capable of recording a colour video signal by the procedure described in Example 5. This experiment shows that an absorption factor of 20 or greater is necessary for a satisfactory recording medium of this invention.

**Claims**

1. A medium for recording at least $5 \times 10^6$ bits per second of information which is pulse-encoded on a recording beam of high energy density radiation, said medium comprising a support bearing a recording layer, characterized in that,

(1) the recording layer has a thickness of less than 0.45 µm and consists of an amorphous material comprising a thermoplastic binder and a dye,

(2) the amorphous material has an absorption factor of at least 20 at a first wavelength and is substantially transparent at a second wavelength wherein the absorption factor is the product of the weight fraction of dye in the recording layer and the molar extinction coefficient of the dye at the wavelength of a recording beam divided by the molecular weight of the dye, and

(3) the amorphous material is capable of being thermally deformed by a beam of high energy density radiation of said first wavelength scanned in relative motion to the recording layer to form deformations comprising depressions or holes surrounded by sharply defined ridges, the width R of each ridge being less than or equal to the breadth D of the depression or hole, as measured in the plane of the undeformed surface of the layer and in the direction of the relative motion between the recording beam and the layer, which deformations represent encoded information capable of being detected by a beam of high energy density radiation of said second wavelength.

2. A medium according to claim 1 wherein the size of each deformation comprising R+D+R is less than 1.5 µm.

3. A medium according to claim 1 or claim 2 wherein the recording layer is solvent-coated on the support.

4. A medium according to any one of claims 1 to 3 wherein the recording layer comprises one part by weight of cellulose nitrate and one part by weight of:

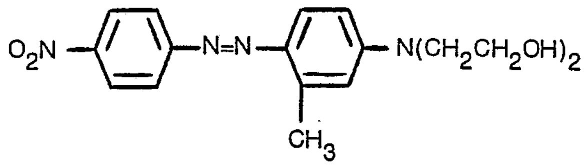

5. A medium according to any one of claims 1 to 3 wherein the recording layer comprises one part by weight of cellulose nitrate and one part by weight of:

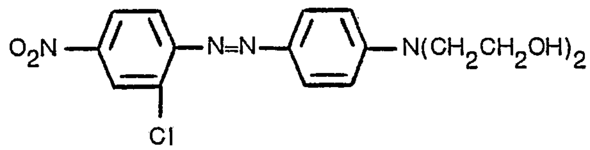

6. A medium according to any one of claims 1 to 3 wherein the recording layer comprises one part by weight of cellulose nitrate and one part by weight of:

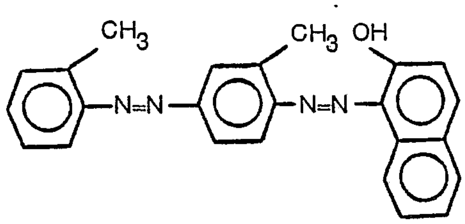

7. A medium according to any one of claims 1 to 3 wherein the recording layer comprises one part by weight of cellulose nitrate and one part by weight of:

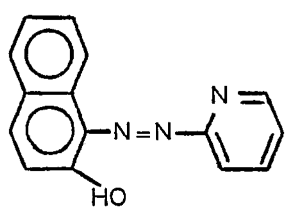

8. A medium according to any one of claims 1 to 3 wherein the recording layer comprises one part by weight of hydroabietyl alcohol and one part by weight of:

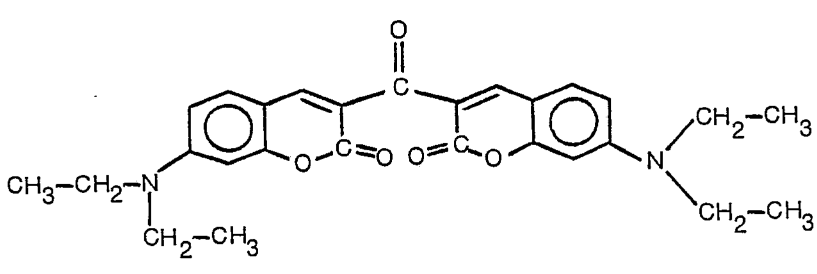

9. A medium according to any one of claims 1 to 3 wherein the recording layer comprises one part by weight of hydroabietyl alcohol and one part by weight of:

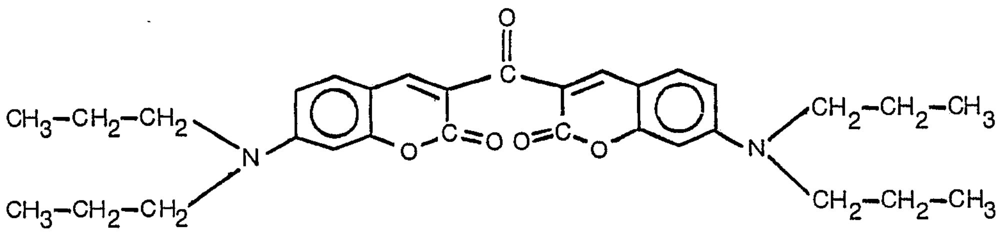

10. A medium according to any one of claims 1 to 3 wherein the recording layer comprises from one to three parts by weight of cellulose nitrate and one part by weight of:

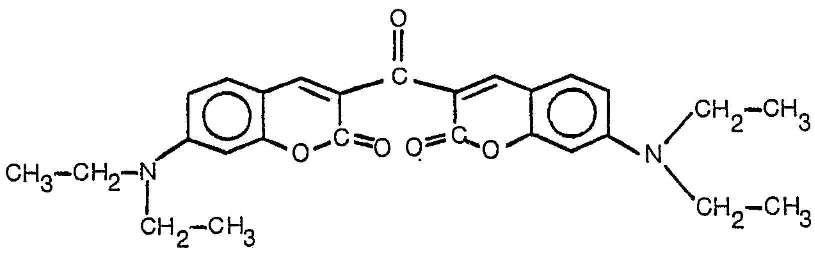

11. A medium according to any one of claims 1 to 3 wherein the recording layer comprises from one to three parts by weight of cellulose nitrate and one part by weight of:

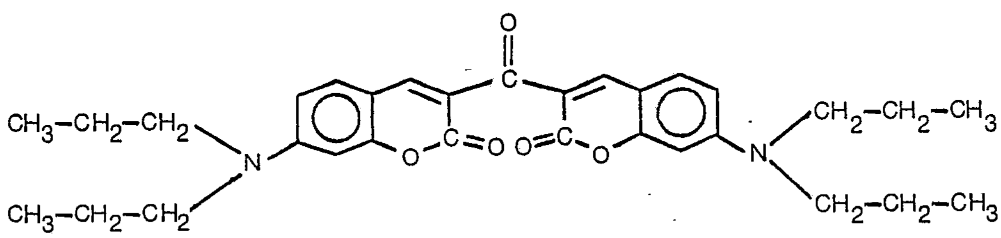

12. A medium according to any one of claims 1 to 3 wherein the recording layer comprises one part by weight of hydroabietyl alcohol, one part by weight of cellulose nitrate and one part by weight of:

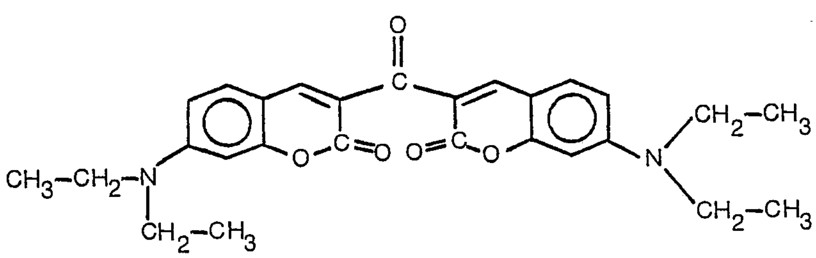

13. A medium according to any one of claims 1 to 3 wherein the recording layer comprises one part by weight of hydroabietyl alcohol, one part by weight of cellulose nitrate and one part by weight of:

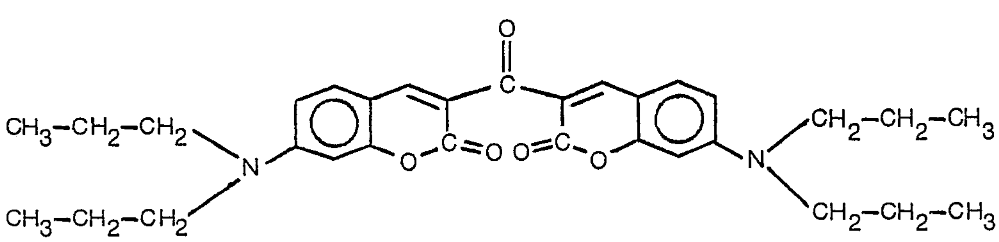

14. A medium according to any one of claims 1 to 3 wherein the recording layer comprises one part by weight of cellulose nitrate and from one to three parts by weight of the dye "losol Red".

15. A method of writing information which is pulse-encoded on a recording beam of high energy density radiation on a medium for recording at least $5 \times 10^6$ bits per second of information comprising a support bearing a recording layer wherein the recording beam is scanned in relative motion to the recording layer, characterized in that

(1) the recording layer has a thickness of less than 0.45 µm and consists of an amorphous material comprising a thermoplastic binder and a dye,

(2) the amorphous material has an absorption factor of at least 20 at a first wavelength and is substantially transparent at a second wavelength wherein the absorption factor is the product of the weight fraction of dye in the recording layer and the molar extinction coefficient of the dye at the wavelength of a recording beam divided by the molecular weight of the dye, and

(3) the recording beam is of the first wavelength and produces a plurality of deformations in the recording layer, said deformations comprising depressions or holes surrounded by sharply defined ridges, the width R of each ridge being less than or equal to the breadth D of the depression or hole, as measured in the plane of the undeformed surface of the layer and in the direction of relative motion between the recording beam and the layer, which deformations represent encoded information capable of being detected by a beam of high energy density radiation of said second wavelength.

16. A method according to claim 15 wherein the recording medium is a medium as claimed in any one of claims 2 to 14 and the recording beam of high energy density radiation is an argon ion laser beam.

**Patentansprüche**

1. Medium zum Aufzeichnen von mindestens $5 \times 10^6$ Bits Informationen pro Sekunde, die auf einem Aufzeichnungsstrahl einer Strahlung hoher Energiedichte Impuls — kodiert sind, wobei das Medium einen Träger und eine auf diesem befindliche Aufzeichnungsschicht aufweist, dadurch gekennzeichnet, daß

(1) die Aufzeichnungsschicht eine Dicke von weniger als 0,45 µm aufweist und aus einem amorphen Material aus einem thermoplastischen Bindemittel und einem Farbstoff besteht,

(2) das amorphe Material bei einer ersten Wellenlänge einen Absorptionsfaktor von mindestens 20 hat und bei einer zweiten Wellenlänge praktisch transparent ist, wobei der Absorptionsfaktor das Produkt aus dem Gewichtsteil des Farbstoffes in der Aufzeichnungsschicht und dem molaren Extinktionskoeffizienten des Farbstoffes bei der Wellenlänge eines Aufzeichnungsstrahles dividiert durch das Molekulargewicht des Farbstoffes ist und

(3) das amorphe Material mittels eines Strahles einer Strahlung hoher Energiedichte der ersten Wellenlänge thermisch de formiert werden kann, der in relativer Bewegung zur Aufzeichnungsschicht geführt wird, unter Ausbildung von Deformationen mit Vertiefungen oder Löchern, die von scharf ausgeprägten Stegen umgeben sind, wobei die Breite R eines jeden Steges geringer als oder gleich ist der Breite D der Vertiefung oder des Loches, gemessen in der Ebene der nicht deformierten Oberfläche der Schicht und in der Richtung der relativen Bewegung zwischen dem Aufzeichnungsstrahl und der Schicht und wobei die Deformationen kodierte Informationen darstellen, die von einem Strahl einer Strahlung hoher Energiedichte der zweiten Wellenlänge erfaßt werden können.

2. Medium nach Anspruch 1, dadurch gekennzeichnet, daß die Größe jeder Deformation aus R+D+R bei weniger als 1,5 µm liegt.

3. Medium nach Anspruch 1 oder 2, dadurch gekennzeichnet, daß die Aufzeichnungsschicht nach dem Lösungsmittel-Beschichtungsverfahren auf den Träger aufgezeichnet ist.

4. Medium nach einem der Ansprüche 1 bis 3, dadurch gekennzeichnet, daß die Aufzeichnungsschicht auf einen Gewichtsteil Cellulosenitrat einen Gewichtsteil der folgenden Verbindung enthält:

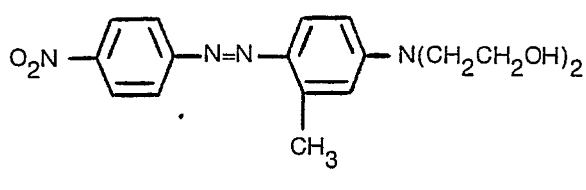

5. Medium nach einem der Ansprüche 1 bis 3, dadurch gekennzeichnet, daß die Aufzeichnungsschicht auf einen Gewichtsteil Cellulosenitrat einen Gewichtsteil der folgenden Verbindung enthält:

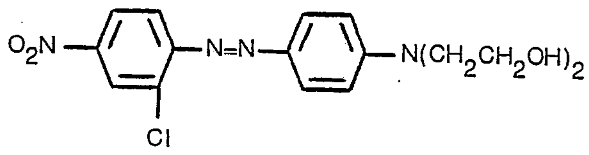

6. Medium nach einem der Ansprüche 1 bis 3, dadurch gekennzeichnet, daß die Aufzeichnungsschicht auf einen Gewichtsteil Cellulosenitrat einen Gewichtsteil der folgenden Verbindung enthält:

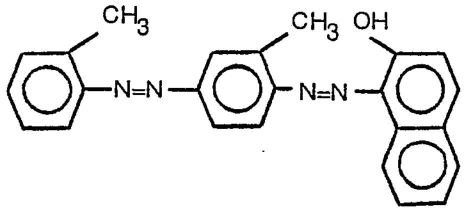

7. Medium nach einem der Ansprüche 1 bis 3, dadurch gekennzeichnet, daß die Aufzeichnungsschicht auf einen Gewichtsteil Cellulosenitrat einen Gewichtsteil der folgenden Verbindung enthält:

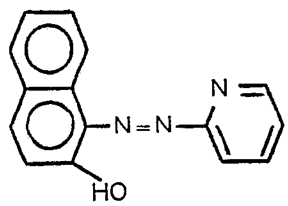

8. Medium nach einem der Ansprüche 1 bis 3, dadurch gekennzeichnet, daß die Aufzeichnungsschicht auf einen Gewichtsteil Hydro-abietylalkohol einen Gewichtsteil der folgenden Verbindung enthält:

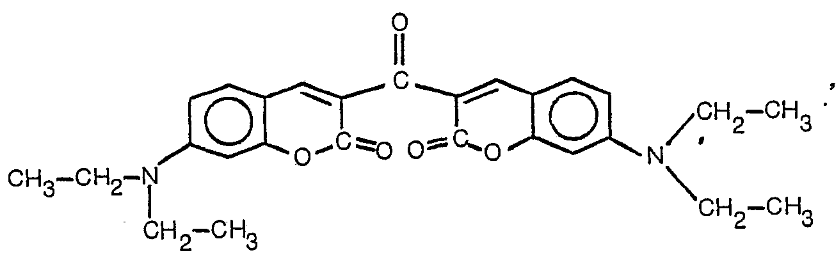

9. Medium nach einem der Ansprüche 1 bis 3, dadurch gekennzeichnet, daß die Aufzeichnungsschicht auf einen Gewichtsteil Hydroabietylalkohol einen Gewichtsteil der folgenden Verbindung enthält:

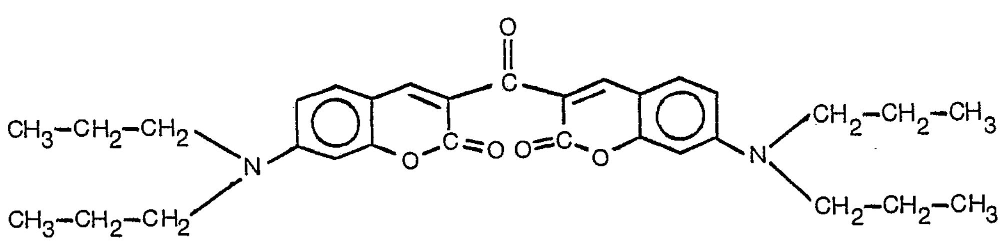

10. Medium nach einem der Ansprüche 1 bis 3, dadurch gekennzeichnet, daß die Aufzeichnungsschicht auf ein bis drei Gewichtsteile Cellulosenitrat einen Gewichtsteil der folgenden Verbindung enthält:

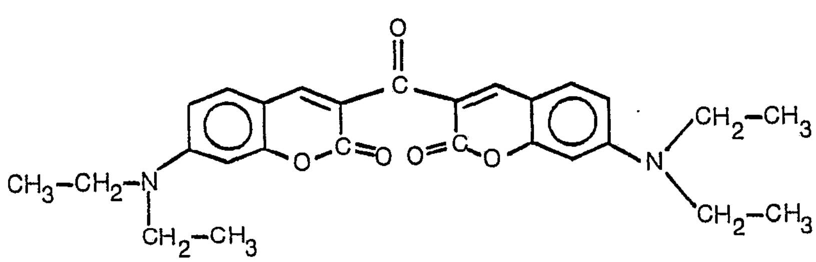

11. Medium nach einem der Ansprüche 1 bis 3, dadurch gekennzeichnet, daß die Aufzeichnungsschicht auf ein bis drei Gewichtsteile Cellulosenitrat einen Gewichtsteil der folgenden Verbindung enthält:

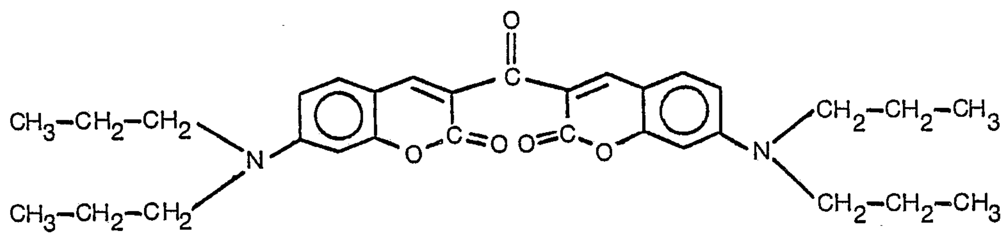

12. Medium nach einem der Ansprüche 1 bis 3, dadurch gekennzeichnet, daß die Aufzeichnungsschicht auf einen Gewichtsteil Hydroabietylalkohol einen Gewichtsteil Cellulosenitrat und einen Gewichtsteil der folgenden Verbindung enthält:

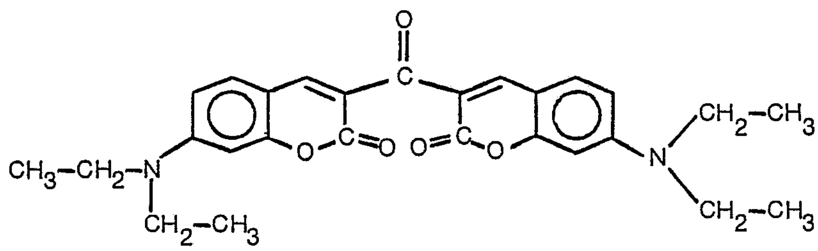

13. Medium nach einem der Ansprüche 1 bis 3, dadurch gekennzeichnet, daß die Aufzeichnungsschicht auf einen Gewichtsteil Hydroabietylalkohol einen Gewichtsteil Cellulosenitrat und einen Gewichtsteil der folgenden Verbindung enthält:

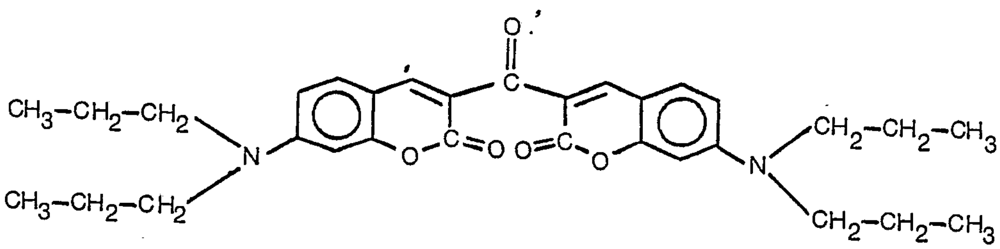

14. Medium nach einem der Ansprüche 1 bis 3, dadurch gekennzeichnet, daß die Aufzeichnungsschicht auf ein Gewichtsteil Cellulosenitrat ein bis drei Gewichtsteile des Farbstoffs "Iosol Red" enthält.

15. Verfahren zum Aufzeichnen von Informationen, die auf einem Aufzeichnungsstrahl hoher Energiedichte Impuls — kodiert sind, auf einem Medium zum Aufzeichnen von mindestens $5 \times 10^6$ Bits Informationen pro Sekunde mit einem Träger, auf den eine Aufzeichnungsschicht aufgetragen ist, bei dem der Aufzeichnungsstrahl in relativer Bewegung zur Aufzeichnungsschicht geführt wird, dadurch gekennzeichnet, daß

(1) die Aufzeichnungsschicht eine Dicke von weniger als 0,45 µm hat und aus einem Material mit einem thermoplastischen Bindemittel und einem Farbstoff besteht,

(2) das amorphe Material bei einer ersten Wellenlänge einen Absorptionsfaktor von mindestens 20 hat und bei einer zweiten Wellenlänge praktisch transparent ist, wobei der Absorptionsfaktor das Produkt aus dem Gewichtsanteil des Farbstoffs in der Aufzeichnungsschicht und dem molaren Extinktionskoeffizienten des Farbstoffs bei der Wellenlänge eines Aufzeichnungsstrahles dividiert durch das Molekulargewicht des Farbstoffes ist und

(3) der Aufzeichnungsstrahl von der ersten Wellenlänge ist und eine Vielzahl von Deformationen in der Aufzeichnungsschicht erzeugt, wobei die Deformationen Vertiefungen oder Löcher aufweisen, die von stark ausgeprägten Stegen umgeben sind, wobei die Breite R eines jeden Steges geringer als oder gleich ist der Breite D der Vertiefung oder des Loches, gemessen in der nicht deformierten Oberfläche der Schicht und in der Richtung der relativen Bewegung zwischen dem Aufzeichnungsstrahl und der Schicht, und wobei die Deformationen kodierte Informationen darstellen, die von einem Strahl einer Strahlung hoher Energiedichte der zweiten Wellenlänge erfaßt werden können.

16. Verfahren nach Anspruch 15, dadurch gekennzeichnet, daß das Aufzeichnungsmedium ein Medium nach einem der Ansprüche 2 bis 14 ist und der Aufzeichnungsstrahl einer Strahlung hoher Energiedichte ein Argonionenlaserstrahl ist.

**Revendications**

1. Produit pour enregistrer au moins $5 \times 10^6$ bits d'information par seconde, cette information étant codée par impulsions dans un faisceau enregistreur de rayonnement à haute densité d'énergie, ce produit comprenant un support sur lequel est appliquée une couche d'enregistrement et étant caractérisé en ce que

(1) la couche d'enregistrement a une épaisseur inférieure à 0,45 µm et est constituée d'une substance amorphe comprenant un liant thermoplastique et un colorant,

(2) la substance amorphe présente un facteur d'absorption d'au moins 20 à une première longueur d'onde et est pratiquement transparente à une deuxième longueur d'onde, le facteur d'absorption étant le produit de la fraction en masse du colorant dans la couche d'enregistrement par le coefficient d'extinction molaire du colorant à la longueur d'onde du faisceau enregistreur divisé par la masse moléculaire du colorant et,

(3) la substance amorphe peut être déformée thermiquement par un faisceau de rayonnement à haute densité d'énergie de la dite première longueur d'onde, balayé en mouvement relatif par rapport à la couche d'enregistrement pour former des déformations comprenant des creux ou des trous entourés de nervures finement délimitées, la largeur R de chaque nervure étant inférieure ou égale à la largeur D du creux ou du trou, telle que mesurée dans le plan de la surface non déformée de la couche et dans la direction du mouvement relatif entre le faisceau enregistreur et la couche, ces déformations représentant une information codée susceptible d'être détectée par un faisceau de rayonnement à haute densité d'énergie de la dite deuxième longueur d'onde.

2. Produit conforme à la revendication 1, dans lequel la dimension de chaque déformation qui comprend $R + D + R$ est inférieure à 1,5 µm.

3. Produit conforme à la revendication 1 ou 2, dans lequel la couche d'enregistrement est déposée sur le support à partir d'une solution.

4. Produit conforme à l'une quelconque des revendications 1 à 3, dans lequel la couche d'enregistrement comprend une partie en masse de nitrate de cellulose et une partie en masse de:

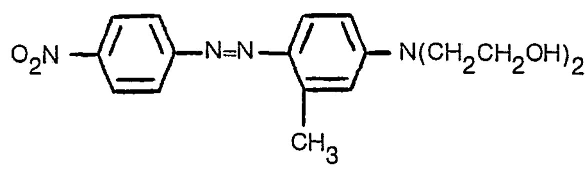

5. Produit conforme à l'une quelconque des revendications 1 à 3, dans lequel la couche d'enregistrement comprend une partie en masse de nitrate de cellulose et une partie en masse de:

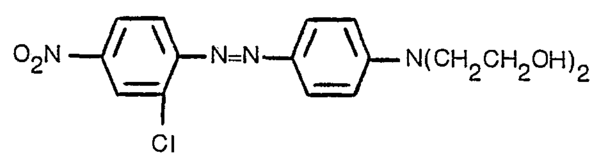

6. Produit conforme à l'une quelconque des revendications 1 à 3, dans lequel la couche d'enregistrement comprend une partie en masse de nitrate de cellulose et une partie en masse de:

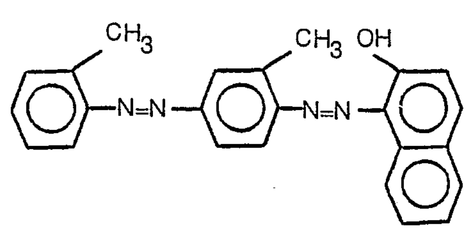

7. Produit conforme à l'une quelconque des revendications 1 à 3, dans lequel la couche d'enregistrement comprend une partie en masse de nitrate de cellulose et une partie en masse de:

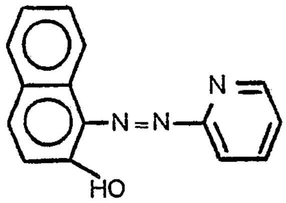

8. Produit conforme à l'une quelconque des revendications 1 à 3, dans lequel la couche d'enregistrement comprend une partie en masse d'alcool hydroabiétylique et une partie en masse de:

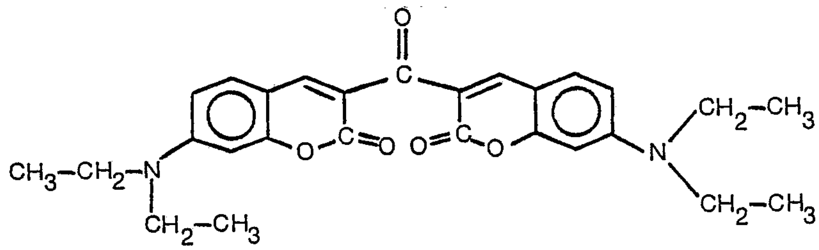

9. Produit conforme à l'une quelconque des revendications 1 à 3, dans lequel la couche d'enregistrement comprend une partie en masse d'alcool hydroabiétylique et une partie en masse de:

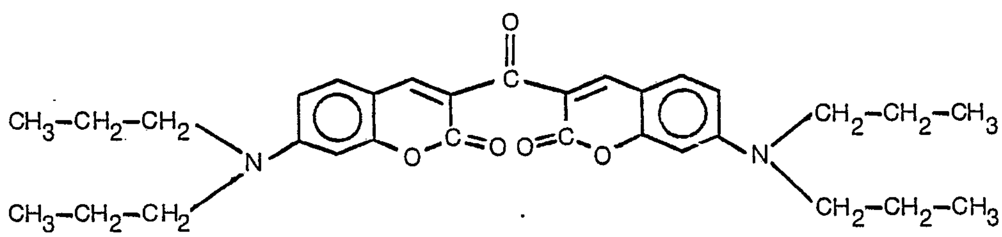

10. Produit conforme à l'une quelconque des revendications 1 à 3, dans lequel la couche d'enregistrement comprend une à trois parties en masse de nitrate de cellulose et une partie en masse de:

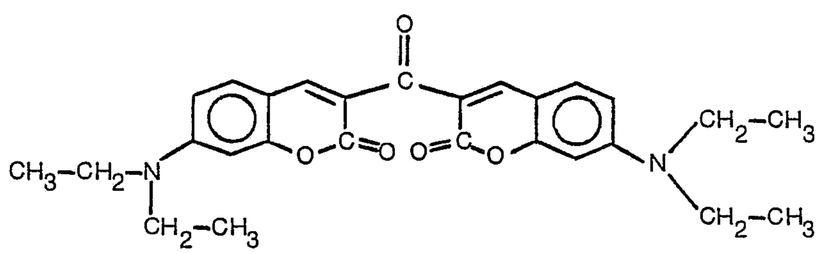

11. Produit conforme à l'une quelconque des revendications 1 à 3, dans lequel la couche d'enregistrement comprend une à trois parties en masse de nitrate de cellulose et une partie en masse de:

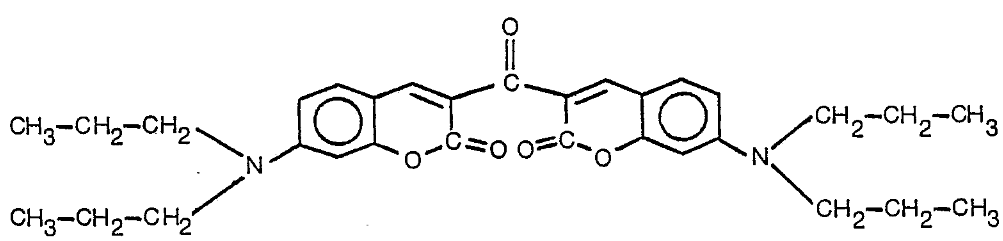

12. Produit conforme à l'une quelconque des revendications 1 à 3, dans lequel la couche d'enregistrement comprend une partie en masse d'alcool hydroabiétylique, une partie en masse de nitrate de cellulose et une partie en masse de:

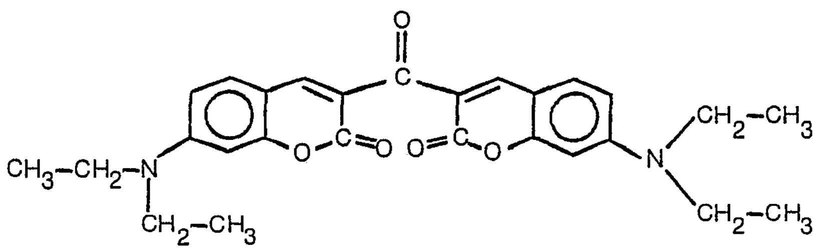

13. Produit conforme à l'une quelconque des revendications 1 à 3, dans lequel la couche d'enregistrement comprend une partie en masse d'alcool hydroabiéthylique, une partie en masse de nitrate de cellulose et une partie en masse de:

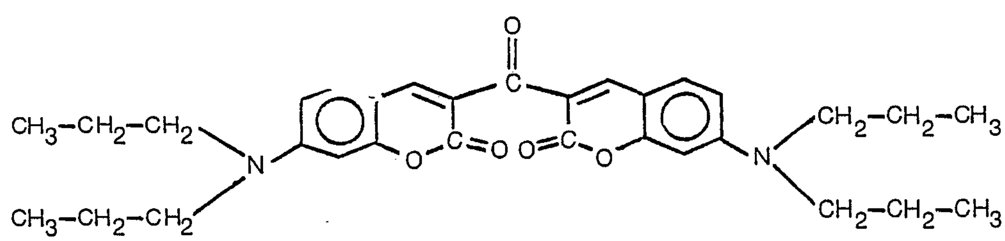

14. Produit conforme à l'une quelconque des revendications 1 à 3, dans lequel la couche d'enregistrement comprend une partie en masse de nitrate de cellulose et une à trois parties en masse du colorant Rouge Iosol.

15. Procédé pour enregistrer une information qui est codée par impulsions dans un faisceau enregistreur de rayonnement à haute densité d'énergie, sur un produit pour enregistrer au moins $5 \times 10^6$ bits d'information par seconde, qui comprend un support sur lequel est appliquée une couche d'enregistrement, le faisceau enregistreur étant balayé en mouvement relatif par rapport à la couche d'enregistrement, procédé caractérisé en ce que

(1) la couche d'enregistrement a une épaisseur inférieure à 0,45 µm et est constituée d'une substance amorphe comprenant un liant thermoplastique et un colorant,

(2) la substance amorphe présente un facteur d'absorption d'au moins 20 à une première longueur d'onde et est pratiquement transparente à une deuxième longueur d'onde, le facteur d'absorption étant le produit de la fraction en masse du colorant dans la couche d'enregistrement par le coefficient d'extinction molaire du colorant à la longueur d'onde du faisceau enregistreur divisé par la masse moléculaire du colorant, et,

(3) le faisceau enregistreur est de la première longueur d'onde et forme plusieurs déformations dans la couche d'enregistrement, ces déformations comprenant des creux ou des trous entourés de nervures finement délimitées, la largeur R de chaque nervure étant inférieure ou égale à la largeur D du creux ou du trou, telle que mesurée dans le plan de la surface non déformée de la couche et dans la direction du mouvement relatif entre le faisceau enregistreur et la couche, ces déformations représentant une information codée susceptible d'être détectée par un faisceau de rayonnement à haute densité d'énergie de la dite deuxième longueur d'onde.

16. Procédé conforme à la revendication 15, dans lequel le produit d'enregistrement est un produit tel que revendiqué dans l'une quelconque des revendications 2 à 14 et le faisceau enregistreur de rayonnement à haute densité d'énergie est un faisceau laser à ion argon.

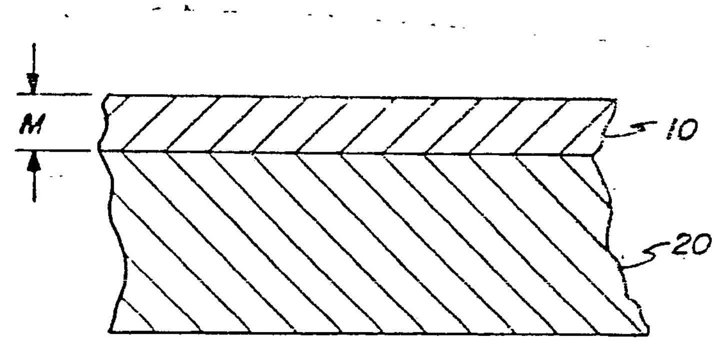


FIG.1

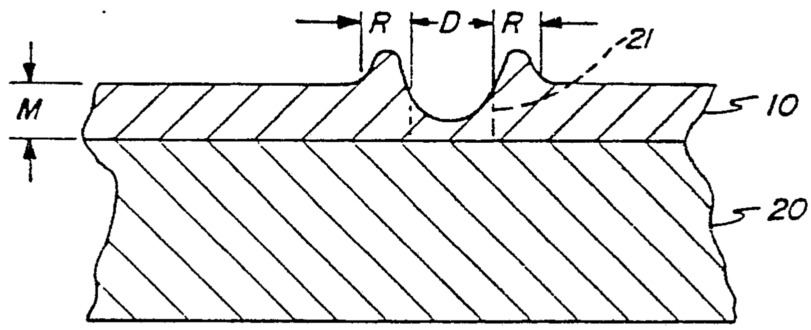


FIG.2

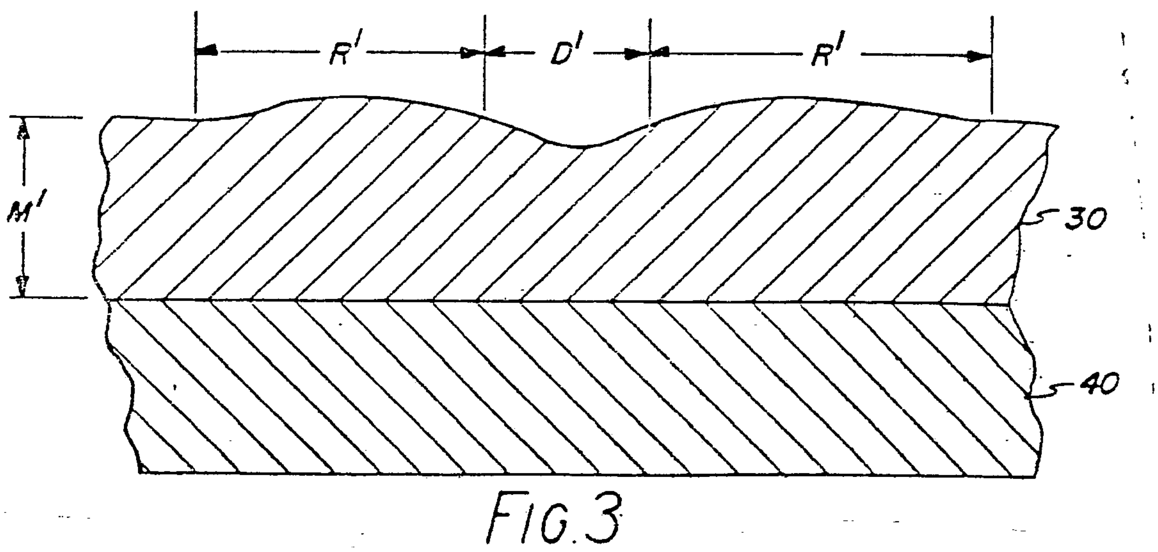


FIG.3